(19) Europäisches Patentamt
European Patent Office
Office européen des brevets

(11) **EP 2 513 697 B1**

(12) **EUROPEAN PATENT SPECIFICATION**

(45) Date of publication and mention
of the grant of the patent:
**07.08.2019 Bulletin 2019/32**

(51) Int Cl.:
***G03F 7/20*** *(2006.01)*    ***G02B 17/06*** *(2006.01)*

(21) Application number: **10792877.2**

(22) Date of filing: **03.12.2010**

(86) International application number:
**PCT/EP2010/068782**

(87) International publication number:
**WO 2011/073039 (23.06.2011 Gazette 2011/25)**

(54) **IMAGING OPTICS**

BILDGEBUNGSOPTIK

ELÉMENT OPTIQUE DE FORMATION D'IMAGE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **14.12.2009 US 286066 P**

(43) Date of publication of application:
**24.10.2012 Bulletin 2012/43**

(73) Proprietor: **Carl Zeiss SMT GmbH
73447 Oberkochen (DE)**

(72) Inventors:
- **MANN, Hans-Jürgen
  73447 Oberkochen (DE)**
- **ENDRES, Martin
  89551 Königsbronn (DE)**
- **SHAFER, David
  Fairfield, Connecticut 06430 (US)**
- **WARM, Berndt
  90571 Schwaig (DE)**
- **HERKOMMER, Alois
  73431 Aalen (DE)**

(74) Representative: **Rau, Schneck & Hübner
Patentanwälte Rechtsanwälte PartGmbB
Königstraße 2
90402 Nürnberg (DE)**

(56) References cited:
**DE-A1-102008 042 917   US-A- 5 220 590
US-A1- 2003 147 131   US-B1- 6 353 470
US-B1- 6 549 270**

EP 2 513 697 B1

**Description**

The invention relates to an imaging optics for lithographic projection exposure. The invention further relates to an illumination system comprising an imaging optics of this type and an illumination optics, a projection exposure apparatus comprising an illumination system of this type, a method for the fabrication of a microstructured or nanostructured component by means of a projection exposure apparatus of this type. An imaging optics of this type may also be used for inspection of reflective lithographic masks and exposed wafers, and may, in the form of an inspection objective, in particular be part of a semiconductor inspection device.

An imaging optics of the type named at the outset is known from US 2009/0073392 A1, from US 2008/0170310 A1, and from US 6,894,834 B2. An imaging optics is further known form US 2003/0147131 A1, US 6 549 270 B1, DE 10 2008 042 917 A1 and US 6 353 470 B1.

It is an object of the present invention to develop an imaging optics of the type named at the outset in such a way as to allow a reflective object to be imaged at high image quality.

This object is achieved according to the invention by an imaging optics having the features set out in claim 1.

It has been found according to the invention that a chief ray angle of an object field point smaller than 3° causes shading effects on the reflective object to be reduced or avoided completely. The chief ray of an object field point is defined as the connection line between the respective object field point and a center of a pupil of the imaging optics even if, for instance as a result of a pupil obscuration, no actual imaging ray is able to pass through the imaging optics along the chief ray. The chief ray angle of the object field points disposed at least among half the extension of the entire object field may be smaller than 3°. The chief ray angle of all object field points may be smaller than 3° as well. The inventive chief ray angle may be smaller than 2°, may be smaller than 1°, and may in particular amount to 0°. Undesirable shading problems, which may occur in conventional systems with chief ray angles of 6° or 8°, are thus avoided. The result is an imaging optics which allows the reflective object to be imaged at an advantageously low CD (critical dimension) variation. The maximum angles of reflection of the imaging rays on the object side in high-aperture imaging optical systems with the inventive chief ray angle are as small as possible, with the result that shading problems are minimized. The inventive imaging optics is designed for beam-splitter-free imaging. In the imaging beam path, there is thus no beam splitter as used in particular prior art illumination systems, for instance in an illumination according to Figure 6 of US 6,894,834 B2, for coupling in illumination light and for imaging light to pass through. An inventive near-field mirror M is provided if the following condition is fulfilled:

$$P(M) = D(SA)/(D(SA)+D(CR)) \leq 0{,}9.$$

In this equation, D(SA) is the sub-aperture diameter of a ray bundle emitted by an object field point at the site of the mirror M while D(CR) is the maximum distance of chief rays of an effective object field imaged by the imaging optics, measured in a reference plane of the optical system, on the surface of the mirror M. The reference plane may be a symmetry plane or a meridional plane of the imaging optics. The definition of the parameter P(M) corresponds to the one stated in WO 2009/024 164 A1.

In a field plane, P(M) amounts to 0. In a pupil plane, P(M) amounts to 1.

In the embodiments of US 6 894 834 B2, P(M) is greater than 0.9 for all mirrors.

At least one of the mirrors of the imaging optics may have a value of P(M) amounting to no more than 0.8, to no more than 0.7, to no more than 0.65, or even to no more than 0.61. Several of the mirrors may also have values of P(M) which are smaller than 0.9, which are smaller than 0.8, or which are even smaller than 0.7.

A near-field mirror of this type may be used for correcting an imaging error. In particular in extended fields, a near-field mirror allows imaging errors to be corrected across the entire extended field. In particular a telecentricity correction may be performed via the near-field mirror. An imaging scale of the imaging optics, in particular a reduction scale of an imaging from the object field to the image field may be 2x, 3x or even 4x. The imaging scale may be absolutely smaller than 8x. At a defined numerical aperture near the image field, a sufficiently small imaging scale results in a correspondingly large numerical aperture near the object field and in a correspondingly smaller object field at a defined image field size. This may be used for reducing an obscuration, and in particular for reducing the width of through-openings in mirrors of the imaging optics.

The imaging optics may have a reduction which is absolutely smaller than 8x, which is smaller than 6x, which is smaller than 5x, which is smaller than 4x, which is smaller than 3x, and which may amount to 2x. An absolutely small imaging scale facilitates the guidance of bundles in the imaging optics. The size of the image field of the imaging optics may be greater than 1 mm$^2$, and may in particular be greater than 1mm x 5 mm, may be greater than 5 mm x 5 mm, and may in particular amount to 10 mm x 10 mm or 20 mm x 20 mm. This ensures a high throughput if the imaging optics is used for lithographic purposes. If the imaging optics is used for inspection of a lithographic mask or an exposed wafer, the above discussed "image field" is used as a field to be inspected on the mask or on the wafer, respectively. In this additional field of application, where the imaging optics is used for inspection purposes, the above discussed image field is therefore rather an inspection object field.

The object named at the outset is also achieved by an imaging optics having the features set out in claim 2. The first mirror of this imaging optics may be part of a first obscured mirror group; the through-opening of said first mirror may be used for coupling in illumination light. Likewise, a last mirror in the imaging beam path between the object field and the image field may have a through-opening for imaging light to pass through. The last mirror in the imaging beam path may then be part of another obscured mirror group, which may result in a large numerical aperture on the image side of the imaging optics. The mirror of the imaging optics having a continuous or closed reflection surface, in other words where no through-opening is provided, allows telecentricity errors of the imaging optics to be corrected. At least one mirror of this type being provided with a continuous reflection surface may be arranged near-field and in particular in the region of an intermediate image plane of the imaging optics. The imaging optics may be provided with a first obscured mirror group and with a second non-obscured mirror group which images the imaging light into the image field without any other obscured mirror groups disposed in-between. The at least one mirror which is provided with a closed reflection surface for reflection of the imaging light may have a parameter P(M) as defined above which may amount to no more than 0.9, to no more than 0.8, to no more than 0.7, to no more than 0.65, and which may even amount to only 0.61. The advantages of a near-field mirror of this type correspond to those explained above.

According to an aspect of the invention it is provided an imaging optics for lithographic projection exposure for guiding a bundle of imaging light with a wavelength shorter than 193 nm by means of a plurality of mirrors for beam-splitter-free imaging of a reflective object in an object field in an object plane into an image field in an image plane, which imaging optics has a design such that imaging light of only the +/- first order of diffraction and/or a higher order of diffraction is used for imaging.

Using only imaging light of the +/- first order of diffraction and/or a higher order of diffraction allows the area where the zero order of diffraction is generated to be used for coupling in illumination light. Using the at least +/- first order of diffraction and, if necessary, even higher orders of diffraction results in an image with a good contrast ratio as the zero order of diffraction is not used. This applies in particular if only the +/- first order of diffraction is used for imaging.

In particular when installed in a pupil-obscured optical system, the inventive imaging optical systems may in particular have a through-opening or a through-bore. In the pupil plane of an imaging optics comprising mirrors of this type, there is an inner area of a bundle of imaging light which is not used for imaging. In this area, there may be arranged a coupling mirror of the illumination optics.

The inventive imaging optics may comprise combinations of features of the imaging optical systems discussed above. In an imaging optics of this type, which cooperates with an illumination optics where the illumination light is guided to the reflective object via a small illumination numerical aperture at small angles of incidence, the resolution limit is reached without requiring a multipole arranged and/or an illumination using angles of incidence which are inclined to the greatest possible extent, in particular without requiring a dipole or quadupole illumination. Furthermore, it is not required to switch between different multipole illumination arrangements for different arrangements of structures on the reflective object to be imaged. The reflective object may be exposed to static illumination and may be illuminated using at least one stop and/or may be illuminated using a zoom objective. The illumination optics may be designed without particular pupil forming components. The illumination optics may in particular be designed without faceted mirrors.

A mirror design according to claim 3 facilitates coupling-in of illumination light which impinges upon the reflective object energy weighted at very low angles of incidence.

According to another aspect, an illumination optics for lithographic projection exposure for beam-splitter-free guidance of a bundle of illumination light with a wavelength shorter than 193 nm from a radiation source to an object in an object field in an object plane, the object being reflective for the illumination light, is provided, which illumination optics has a design such that for at least one point of the object field the bundle of the illumination light has an energy weighted ray direction of incidence onto the object field which makes an angle with a normal to the object plane which is smaller than 3°. Such an illumination optics ensures an illumination of a reflective object in order to obtain high-quality images.

An inventive energy weighted or central ray direction of incidence may be centered around an angle of incidence of 0° for at least one point of the object field. At this point, the illumination light impinges upon the reflective object at low angles of incidence so that shading problems occurring during imaging are avoided. The advantages obtained correspond to those explained above with reference to the inventive imaging optical systems. The angle between the energy weighted ray direction of incidence and the normal to the object plane may be smaller than 2°, smaller than 1°, and may amount to exactly 0°. Other energy weighted rays of the illumination light bundle may have larger angles of incidence. A guidance of bundles of the illumination light may start from a direction which is at first approximately parallel to the guidance of imaging light downstream of the object field or which is approximately perpendicular to the guidance of imaging light downstream of the object field, which is referred to as "vertical entrance" and "horizontal entrance" of the illumination light if the imaging light is guided vertically. Instead of using the illumination optics for lithographic projection exposure, the inventive illumination optics may also be employed in an inspection system for examining an object for defects.

Inspection systems of this type are in particular used for reticle and/or wafer inspection.

The bundle of the illumination light may have a maximum angle of incidence onto the object field which is smaller than 10°. Such a maximum angle of incidence significantly reduces shadings of structures on the reflective object. Moreover, if a reflective coating is provided on the reflective object, this ensures an advantageously high reflectivity of the reflective object, and therefore a high throughput of illumination light or imaging light. The maximum angle of incidence may be smaller than 8°, may be smaller than 6°, and may also be smaller than 5°.

The last mirror of the illumination optics in the illumination beam path in front of the object field may comprise a through-opening. Such a design of an illumination optics mirror allows the imaging light emitted by the object field and reflected by the object to be guided through the through-opening of the last mirror of the illumination light, in other words the coupling mirror. An illumination of this type is also referred to as dark field illumination. In this case, the object may only be exposed to light outside an imaging aperture. In particular when imaging object edges, a dark field illumination has advantages over another, conventional illumination. Moreover, the above described advantages of a small angle between the central ray of incidence of the illumination light and the normal to the object field can be combined with those of a conventional and non-obscured imaging optics. A dark field illumination may offer advantages in particular when the illumination optics is employed in an inspection system as this type of illumination allows impurities, scratches or dust in the object field to be imaged at very high contrast.

According to another aspect, an illumination system comprises an imaging optics and an illumination optics as described above. The advantages of such an illumination system correspond to those explained above with reference to the inventive imaging optics and with reference to the inventive illumination optics.

In an illumination system according to claim 5, the through-opening through which the illumination light is coupled in may at the same time define a pupil obscuration of the imaging optics.

The advantages of the alternative arrangement according to claim 6 correspond to those explained above with reference to the illumination optics.

According to claim 7 a projection exposure apparatus comprises an illumination system as described above and a light source for producing the illumination and imaging light.

According to claim 8, a method for the fabrication of a structured component comprises the following steps:

> providing a reticle and a wafer;
> projecting a structure on the reticle onto a light-sensitive layer of the wafer by means of the projection exposure apparatus as described above;
> producing a microstructure or a nanostructure on the wafer.

The advantages of a projection exposure apparatus according to claim 7 and of a fabrication method according to claim 8 correspond to those explained above with reference to the inventive illumination system. The light source may be an EUV (extreme ultraviolet) light source such as an LPP (laser produced plasma) light source or a GDP (gas discharge produced plasma) light source. The inventive imaging optics may not only be employed in a projection exposure apparatus but also in an inspection device in particular for inspection of reflective lithographic masks or for inspection of exposed wafer substrates. The above-discussed image field of the imaging optics is then an inspection object field of the inspection device.

Embodiments of the invention will hereinafter be explained in more detail by means of the drawing in which

Fig. 1 is a schematic view of a projection exposure apparatus for EUV lithography, with an imaging optics of the projection exposure apparatus being shown in a meridional section;

Fig. 2 is another schematic view, which, compared to Fig. 1, is not to scale, of an enlarged section of a beam path of illumination light and imaging light of the projection exposure apparatus according to Fig. 1 in the region of a reflective object in the shape of a reticle to be imaged by projection exposure ("vertical entrance);

Fig. 3 is a view similar to Fig. 2 of an alternative guidance of the illumination light through optical components of a variation of an illumination optics of the projection exposure apparatus ("horizontal entrance");

Figs. 4 and 5 are variations of an imaging optics for use in a projection exposure apparatus according to Fig. 1;

Fig. 6 is a highly schematic view of the beam path in a projection exposure apparatus in the manner of Fig. 1 in the region of the object and in the region of an image at the site of a wafer; and

Fig. 7 is a view similar to Fig. 6 of the beam path relations at an alternative illumination of the object and an alternative image thereof adapted thereto.

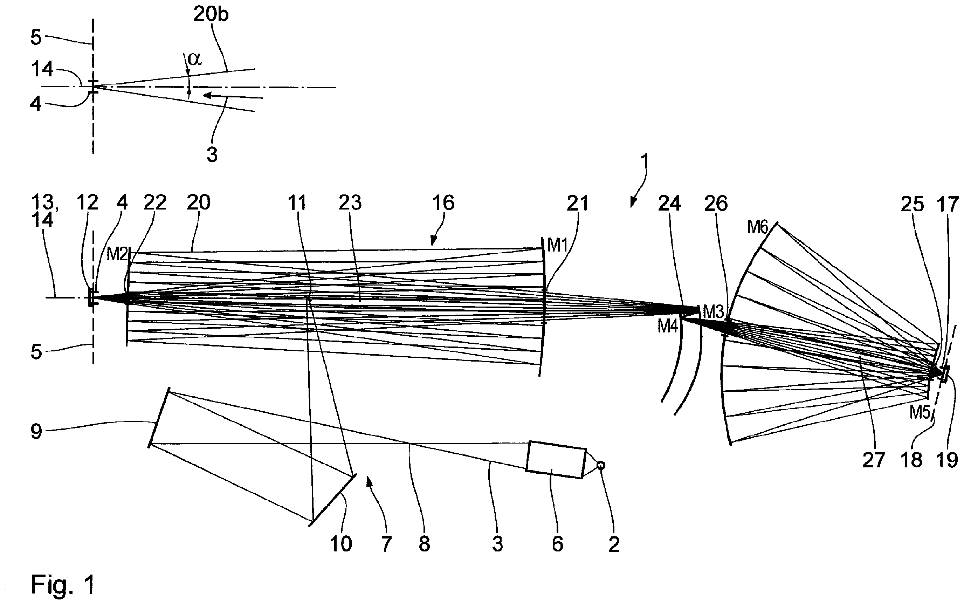

A projection exposure apparatus 1 for lithographic projection exposure for the fabrication of a microstructured or nanostructured component has a light source 2 for illumination light or imaging light 3. The light source 2 is an EUV light source which generates light in a wavelength range of for example between 5 nm and 30 nm, in particular between 5 nm and 10 nm. The light source 2 may in particular be a light source with a wavelength of 6.9 nm or 13.5 nm. Other EUV wavelengths are conceivable as well. Other wavelengths which are used in lithography and for which the suitable light sources are available are conceivable for the illumination light or imaging light 3 guided in the projection exposure apparatus 1. A beam path of the illumination light 3 is shown in an extremely schematic view in Fig. 1.

An illumination optics 7 is used for guiding the illumination light 3 from the light source 2 to an object field 4 in an object plane 5. The illumination light 3 emitted by the light source or radiation source 2 is at first collected by a collector 6. An intermediate focus 8 is typically arranged in the illumination beam path downstream of the collector 6. The illumination beam path may also be designed without the intermediate focus 8 in such a way that the illumination light 3 leaves the collector in a collimated form. A spectral filtering of the illumination light 3 may occur in the region of the collector 6 or the intermediate focus 8. A first mirror 9 of the illumination optics 7 is arranged in the illumination beam path downstream of the intermediate focus 8. Said first illumination optics mirror 9 may be a field facet mirror. A second mirror 10 of the illumination optics 7 is arranged in the illumination beam path downstream of the first illumination optics mirror 9. The second illumination optics mirror may be a pupil facet mirror.

Alternatively, it is conceivable to use an illumination optics without faceted mirror. An illumination optics of this type may have an illumination beam path which corresponds to that of the illumination optics 7 according to Fig. 1.

A coupling mirror 11 of the illumination optics 7 is arranged in the illumination beam path downstream of the second illumination optics mirror 10. The coupling mirror 11 may be supported by a support which corresponds to a support known from Figs. 1k, 1l and 1m of WO 2006/069725 A.

The coupling mirror 11 guides the illumination light 3 to the object field 4 where a reflective object 12 in the form of a reticle or a lithographic mask is arranged.

The partial illumination beam path between the collector 6 and the first illumination optics mirror 9 intersects with the partial illumination beam path between the second illumination optics mirror 10 and the coupling mirror 11.

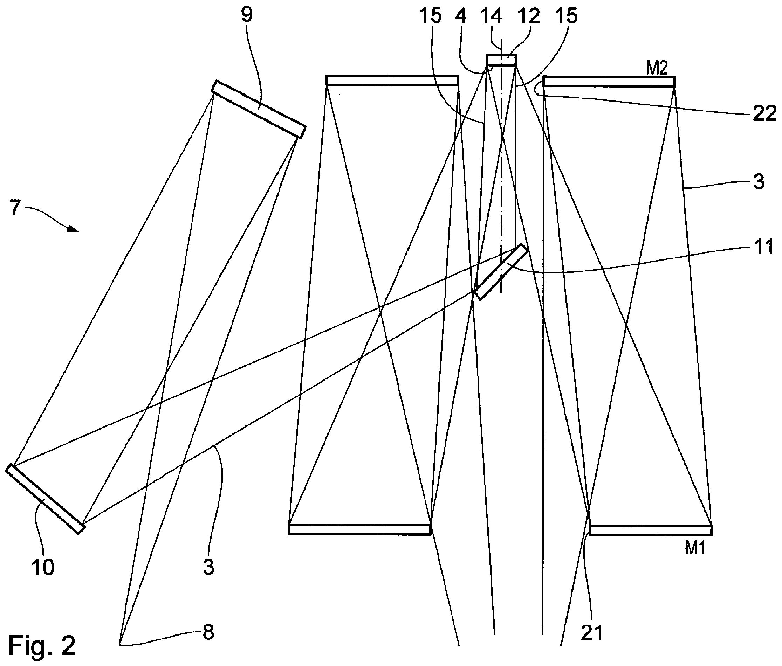

An energy weighted or central ray direction of incidence 13 of a bundle of illumination light 3 impinging upon the reticle 12 coincides exactly with a normal 14 to the object plane 5. The energy weighted ray direction of incidence 13 thus makes an angle with the normal 14 which is smaller than 3° and amounts to exactly 0° in the embodiment according to Fig. 1. Other angles between the energy weighted ray direction of incidence 13 and the normal 14 are conceivable if the design of the illumination optics 7 is slightly modified, for instance angles between the energy weighted ray direction of incidence 13 and the normal 14 amounting to 2.5°, to 2°, 1.5°, 1° or 0.5°. Edge rays 15 (cf. Fig. 2) of the bundle of illumination light 3 impinging upon the reticle 12 make an angle with the normal 14 which is smaller than 3°. The bundle of illumination light 3 impinging upon the reticle 12 therefore has a maximum angle of incidence on the object field 4 which is smaller than 3°.

An imaging optics 16 in the form of a projection optics for guiding the imaging light 3 and for imaging the reticle 12 into an image field 17 in an image plane 18 is arranged in the beam path of the projection exposure apparatus 1 downstream of the object field 4. In the imaging optics 16, the image plane 18 makes an angle with the object plane 5 of approximately 15°. This angle facilitates a design of the imaging optics 16 in terms of a correction of imaging errors, in particular in terms of a correction of telecentricity and aberration across the entire image field 17.

Imaging by means of the imaging optics 16 occurs on the surface of a substrate in the form of a wafer 19. The reticle 12 and the wafer 19 are supported by supports (not shown). The projection exposure apparatus 1 is a scanner. Both the reticle 12 and the wafer 19 are scanned in the object plane 5 on the one hand and in the image plane 18 on the other when the projection exposure apparatus 1 is in use. Using a projection exposure apparatus 1 in the form of a stepper where the reticle 12 on the one hand and the wafer 19 on the other hand are displaced in steps between individual illuminations of the wafer 19 is conceivable as well.

Fig. 1 shows the optical design of a first embodiment of the imaging optics 16. The Figure shows the beam path of a total of ten individual rays 20 of the imaging light 3 emitted by a central field point.

The imaging optics 16 according to Fig. 1 has a total of six mirrors which are numbered from M1 to M6 in the order of the beam path of the individual rays 20 starting from the object field 4. Fig. 1 shows the reflection surfaces of the mirrors M1 to M6 calculated when designing the imaging optics. However, only a section of these surfaces, in particular of the mirrors M3, M4, is actually being used, as shown in Fig. 1.

The mirror M1 is concave. The mirror M2 is convex. The mirror M3 is concave. The mirror M4 is convex. The mirror M5 is convex. The mirror M6 is concave.

Each of the mirrors M1 and M2 has a through-opening 21, 22 for imaging light 3 to pass through. The mirrors M1 and M2 are therefore obscured mirrors. Due to this obscuration, the bundle of imaging light 3 has an inner area in near-pupil regions of the imaging optics 16 where there are no individual rays 20. A free inner area 23 of this type, through which the normal 14 and the central ray of incidence 13 pass, is disposed between the mirrors M1 and M2. In this free area 23 is arranged the coupling mirror 11. The coupling mirror 11 couples the illumination light 3 into the system via the through-opening 23 in the mirror M2 of the imaging optics 16.

A chief ray of a central object field point, which is not part of the beam path because of the obscuration, has a chief ray angle $\alpha$ of 0° in the imaging optics 16. This means that this chief ray of the central object field point coincides with the normal 14 to the object plane 5. The definition of the chief ray angle $\alpha$ is made clear by an insert in Fig. 1 which is a schematic view of the relations when a chief ray with the reference numeral 20b impinges upon the reflective reticle 12 in the object field 4. The chief ray angle $\alpha$ is the angle between the normal 14 and the chief ray 20b reflected by the object field 4.

The two mirrors M3 and M4 arranged in the imaging beam path downstream of the mirror M2 have continuous or closed reflection surfaces for the reflection of the imaging light 3, in other words they have no through-opening. In the region of the imaging beam path near the mirrors M3 and M4 is disposed an intermediate image 24 of the imaging optics 16. The mirrors M3 and M4 are therefore near-field mirrors which are suitable for telecentricity correction of the imaging optics 16.

The mirrors M5 and M6 arranged in the imaging beam path of the imaging optics 16 downstream of the mirror M4 are again provided with through-openings 25, 26.

The mirrors M5 and M6 are therefore obscured mirrors again. Between the mirrors M5 and M6, there is again a free region 27 in the bundle of illumination light 3, the free region 27 being an image of the free region 23.

The mirrors M1 and M2 form a first obscured mirror group of the imaging optics 16. The mirrors M3 and M4 form a non-obscured mirror group of the imaging optics 16. The mirrors M5 and M6 form a second obscured mirror group of the imaging optics 16.

Fig. 2 is an enlarged sectional view of the beam path relations of the illumination and imaging light 3 before and after being reflected at the reticle 12. The first mirror 9 of the illumination optics 7 is arranged relative to the intermediate focus 8 in such a way that the beam path of the illumination light 3 between the intermediate focus 8 and the first illumination optics mirror 9 is substantially parallel to the beam path of the illumination light 3 downstream of the object field 4. The guidance of bundles of the illumination light therefore starts from a direction which is at first approximately parallel to the guidance of the illumination light 3 downstream of the object field 4. Between the intermediate focus 8 and the first illumination optics mirror 9 of the illumination optics 7, a partial illumination beam therefore extends towards the object plane 5 at a small angle to the normal 14. If the normal 14 extends vertically, this is referred to as vertical entrance of the illumination optics 7.

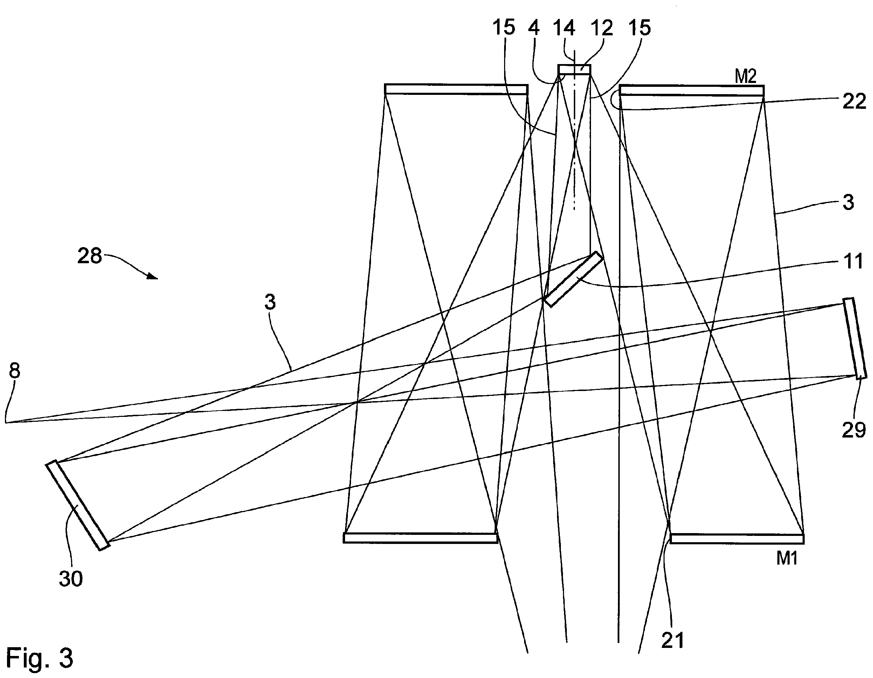

Fig. 3 shows a variation of an arrangement of mirrors guiding the illumination light 3, in other words another embodiment of an illumination optics 28. Components which correspond to those explained above with reference to Figures 1 and 2 have the same reference numerals and are not discussed again.

In the embodiment according to Fig. 3, a first mirror 29 of the illumination optics 28 is arranged relative to the intermediate focus 8 in such a way that the beam path of the illumination light 3 between the intermediate focus 8 and the illumination optics mirror 29 is perpendicular to the bundle guidance of the imaging light 3 downstream of the object field 4. A partial imaging beam between the intermediate focus 8 and the first illumination optics mirror 29 therefore crosses the bundle of imaging light 3. The guidance of bundles of illumination light 3 starts from a direction which is at first approximately perpendicular to the guidance of the imaging light downstream of the object field 4. In the illumination optics 28, a partial illumination beam between the intermediate focus 8 and the first illumination optics mirror 29 extends toward the object plane 5 at approximately right angles to the normal 14. If the normal 14 is vertical, this is referred to as horizontal entrance of the illumination optics 28.

In relation to the bundle of illumination light 3, a second mirror 30 of the illumination optics 28 is arranged on the same side as the intermediate focus. A partial illumination beam between the first illumination optics mirror 29 and the second illumination optics mirror 30 therefore crosses the bundle of imaging light 3 again between the mirrors M1 and M2. The coupling mirror 11 is again arranged in the beam path downstream of the second illumination optics mirror 30.

Arranging the illumination optics mirrors 29, 30 according to Figure 3 results in small angles of incidence of the illumination light 3 on said illumination optics mirrors 29, 30, which provides for a high reflectivity of the illumination optics mirrors 29, 30. The first illumination optics mirror 29 may be a field facet mirror. The second illumination optics mirror 30 may be a pupil facet mirror.

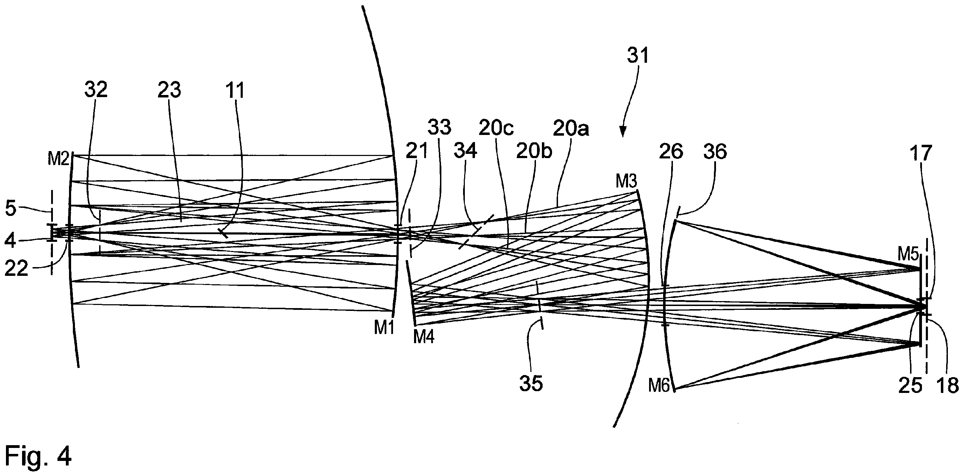

The following is a description, by means of Fig. 4, of another embodiment of an imaging optics 31 which may be employed in the projection exposure apparatus 1 instead of the imaging optics 16. Components which correspond to those described above with reference to Figures 1 and 2 have the same reference numerals and are not discussed again. Fig. 4 shows the respective beam paths of three individual rays 20a, 20b, 20c which are emitted by three object field points which are vertically spaced from each other in Figure 4. The three individual rays 20a, 20b, 20c, which belong to one of these three object field points, are in each case associated to three different illumination directions for the three object field points. The individual rays 20a and 20c are the two coma rays at the edge while the individual rays 20b are the chief rays emitted by the respective object field points. Said chief rays are drawn in Fig. 4 for illustrative purposes only as they extend through the center of a pupil of the imaging optics 31 and are not actual imaging beam paths of the imaging optics 31 due to the central obscuration of the imaging optics 31.

In the imaging beam path of the imaging optics 31, a first pupil plane 32 of the imaging optics 31 is arranged next to the object field 4. The mirror M2 is arranged between the object field 4 and the object plane 32. A first intermediate image plane 33 is disposed on a level with the through-opening 21 in the mirror M1. In the beam path between the mirrors M2 and M3, another pupil plane 34 is arranged downstream of the intermediate image plane 33. Another intermediate image plane 35 is disposed in the illumination beam path between the mirrors M4 and M5. The intermediate image plane 35 is disposed between the mirror M4 and the mirror M6.

Another pupil plane 36 is disposed in the illumination beam path of the imaging optics 31 and is approximately on a level with the mirror M6.

The mirrors M1 and M4 are arranged back-to-back. The mirrors M3 and M6 are also arranged back-to-back.

The imaging optics 31 also has a first obscured mirror group comprising the mirrors M1 and M2, a subsequent non-obscured mirror group comprising the mirrors M3 and M4, and a subsequent obscured mirror group comprising the mirrors M5 and M6.

In the imaging optics 31, the mirrors M1, M2, M3 and M4 are near-field mirrors, in other words they have a parameter

$$P(M) = D(SA)/(D(SA)+D(CR)),$$

the parameter having a value of no more than 0.9.

D(SA) is the sub-aperture diameter of an object field point at the site of the mirror M. D(CR) is the maximum distance of chief rays 20b of an effective object field on the surface of the mirror M in a reference plane, namely in the drawing plane of Figure 4 which is at the same time a mirror symmetry plane of the imaging optics 31.

The following table contains the values for the parameter P(M) of all six mirrors M1 to M6 of the imaging optics 31:

| Mirror | P(M) |
|--------|------|
| M1 | 0.70 |
| M2 | 0.67 |
| M3 | 0.76 |
| M4 | 0.61 |
| M5 | 0.97 |
| M6 | 0.98 |

In the imaging optics 31, the object plane 5 and the image plane 18 are parallel to each other.

The following is a table containing optical design data for the imaging optics 31 obtained by means of the optical design program Code V®.

The mirrors M1 to M6 of the imaging optics 31 are free-form surfaces which are not describable by a rotation-symmetric function. Other designs of the imaging optics 31, where at least one of the mirrors M1 to M6 has a free-form reflection surface of this type, are conceivable as well.

A free-form surface of this type may be obtained from a rotation-symmetric reference surface. Free-form surfaces of this type for reflection surfaces of the mirrors of projection optical systems of microlithographic projection exposure apparatuses are disclosed in US 2007/0058269 A1.

The free-form surface can be described mathematically by the following equation:

$$Z = \frac{cr^2}{1+\sqrt{1-(1+k)c^2r^2}} + \sum_{j=2}^{N} C_j X^m Y^n,$$

with

$$j = \frac{(m+n)^2 + m + 3n}{2} + 1$$

Z is the sagittal height of the free-form surface at the point x, y ($x^2 + y^2 = r^2$).

c is a constant which corresponds to the apex curvature of a corresponding asphere. k corresponds to a conical constant of a corresponding asphere. $C_j$ are the coefficients of the monomials $X^m Y^n$. The values of c, k and $C_j$ are typically determined on the basis of the desired optical properties of the mirror in the projection optics 7. The order of the monomial m + n can be selected randomly. A higher-order monomial may result in a projection optics allowing for better image error correction, the calculation thereof is however much more complicated. m + n may take values of between 3 and more than 20.

It is conceivable as well to mathematically describe free-form surfaces by Zernike polynomials which are explained for example in the manual of the optical design program Code V®. Alternatively, free-form surfaces are describable using two-dimensional spline surfaces such as Bezier curves or non-uniform rational basis splines (NURBS). Two-dimensional spline surfaces may for instance be described by a grid of points in an xy plane and associated z-values, or by these points and associated slopes. Depending on the type of the spline surface, the entire surface is obtained by interpolation between the grid points by using for example polynomials or functions having particular properties in terms of continuity and differentiability. Examples thereof are analytic functions.

The mirrors M1 to M6 have multiple reflection layers optimizing the reflection of incident EUV illumination light 3. The closer the angle of incidence of the individual rays 20 is to vertical incidence when impinging upon the mirror surfaces, the better the reflection.

The first of the following tables contains the reciprocals of the apex curvature (radius) of each of the optical surfaces of the optical components and of the aperture stop as well as a distance value (thickness) corresponding to the z-distance of adjacent elements in the beam path starting from the object plane. The second table contains the coefficients $C_j$ of the monomials $X^m Y^n$ in the above free-form surface equation for the mirrors M1 to M6, with Nradius being a normalizing factor. The third table contains the distance (in mm) along which the respective mirror has been decentered (Y-decenter) and rotated (X-rotation) from a mirror reference design. This corresponds to a parallel translation in the y-direction and a tilting about the x-axis performed when the free-form surface is being designed. The tilting angle is in degrees.

| Surface | Radius | Distance | Mode of operation |
|---|---|---|---|
| Object plane | INFINITE | 132,471 | |
| Stop | INFINITE | 843,400 | |
| M1 | -1147,136 | -925,871 | REFL |
| M2 | 1637,131 | 1651,659 | REFL |
| M3 | -591,859 | -675,787 | REFL |
| M4 | 454,702 | 1453,843 | REFL |
| M5 | 216,642 | -728,056 | REFL |
| M6 | 892,687 | 748,341 | REFL |
| Image plane | INFINITE | 0,000 | |

| Coefficient | M1 | M2 | M3 | M4 | M5 | M6 |
|---|---|---|---|---|---|---|
| K | -5,11E-01 | -4,35E+00 | -5,43E-01 | 9,31E-01 | -9,39E-01 | -6,43E-02 |
| Y | 0,00E+00 | 0,00E+00 | 0,00E+00 | 0,00E+00 | 0,00E+00 | 0,00E+00 |
| X2 | 9,28E-05 | -1,96E-04 | 9,46E-05 | -6,67E-04 | -2,14E-03 | -4,80E-05 |
| Y2 | 1,75E-04 | -7,88E-05 | 2,52E-04 | -1,09E-03 | -2,10E-03 | -3,43E-05 |
| X2Y | -2,33E-08 | -4,77E-09 | 2,62E-07 | 2,67E-07 | -1,59E-07 | -2,73E-08 |
| Y3 | 1,94E-08 | 7,88E-08 | 3,72E-08 | 1,00E-06 | 1,35E-07 | 1,00E-08 |
| Nradius | 1,00E+00 | 1,00E+00 | 1,00E+00 | 1,00E+00 | 1,00E+00 | 1,00E+00 |

| Coeffizient | M1 | M2 | M3 | M4 | M5 | M6 | Image plane |
|---|---|---|---|---|---|---|---|
| Y-decenter | 200,000 | -71,157 | -200,000 | -156,891 | -169,307 | -186,851 | 0,000 |
| X-rotation | 6,174 | 1,909 | -5,745 | 7,869 | -0,353 | 0,115 | 0,000 |

Between the object field 4 and the image field 17, the imaging optics 31 has a reduction of 2x. A numerical aperture on the object side of the imaging optics 31 amounts to 0.15. The object field 4 has a size of 20 mm x 20 mm. A numerical aperture on the image side of the imaging optics 31 amounts to 0.3. The image field 17 in the imaging optics 31 has a size of 10 mm x 10 mm.

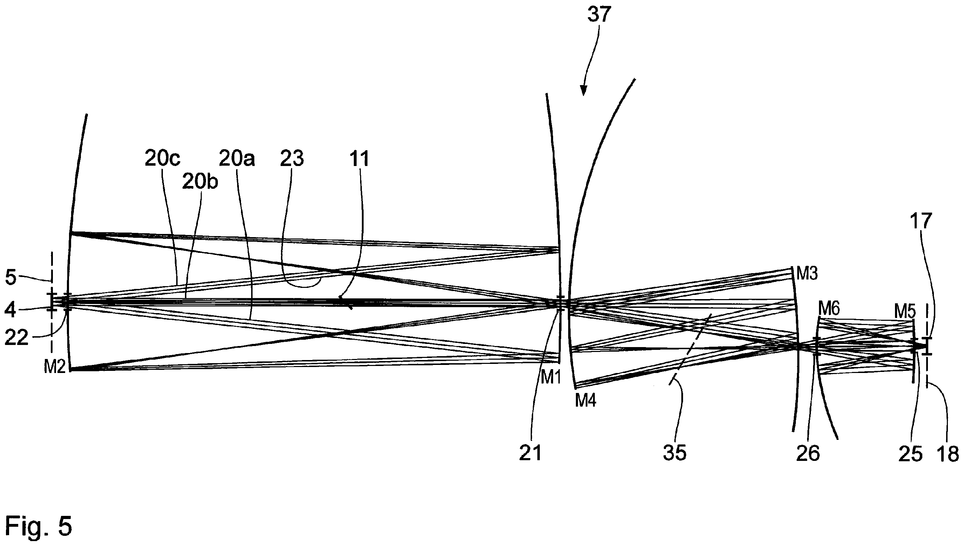

The following is a description, based on Fig. 5, of another embodiment of an imaging optics 37 which may be employed in the projection exposure apparatus 1 instead of the imaging optics 16. Components which correspond to those described above with reference to Figures 1 and 2 have the same reference numerals and are not discussed again.

The illustration of the imaging beam path comprising the individual rays 20a, 20b, 20c corresponds to the illustration according to Fig. 4.

In the imaging optics 37, the object plane 5 and the image plane 18 are parallel to each other.

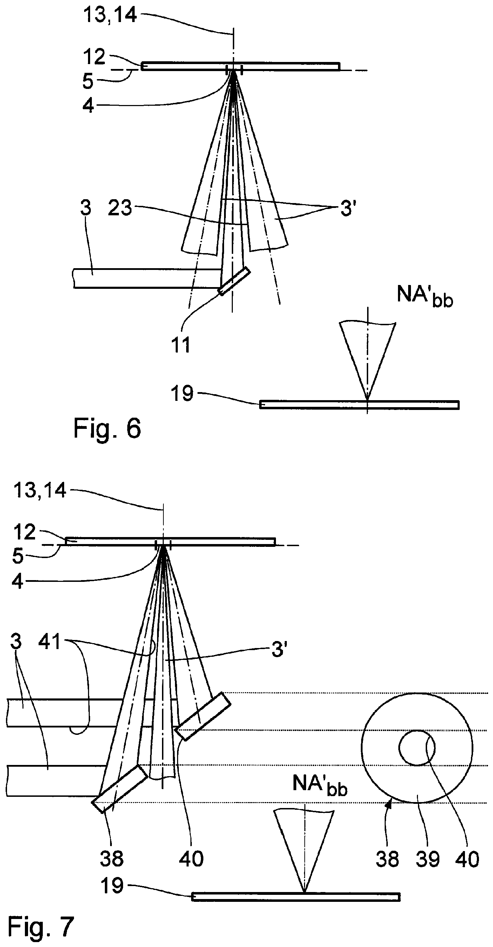

Figs. 6 and 7 outline two basic possibilities of coupling in illumination light 3, with a direction of the central ray of incidence 13 of the illumination light 3 making a virtually negligible angle with the normal 14 to the object plane 5 when impinging upon the reticle 12. The imaging light in Figs. 6 and 7 is referred to with 3', allowing said imaging light 3' to be differentiated from the illumination light 3.

In the illumination example according to Figs. 6 and 7, the normal 14 to the object plane 5 coincides with the direction of the central ray of incidence 13 of the bundle of illumination light 3 when reflected by the coupling mirror 11 and impinging upon the reticle 12.

Fig. 6 shows relations when the illumination light 3 is coupled for impingement upon the reticle 12, the relations corresponding to those explained above with reference to Figs. 1 to 5. In this case, the coupling mirror 11 is disposed in a free area 23 inside the bundle of imaging light 3'. The inner numerical aperture of the radiation bundle of imaging light 3' in the free area 23 is slightly greater than the numerical aperture of the bundle of illumination light 3 impinging upon the reticle 12 after being reflected at the coupling mirror 11. The imaging optics according to Fig. 6 has a numerical aperture NA'$_{Abb}$ on the image side. In the illumination example according to Fig. 6, the bundle of illumination light 3 impinging upon the reticle 12 after being reflected at the coupling mirror 11 has a small maximum angle of incidence which may for instance be smaller than 5°, smaller than 4°, smaller than 3°, smaller than 2°, or smaller than 1°. The maximum angle of incidence is the greatest angle made by one of the individual rays of the bundle of illumination light 3 with the normal 14 to the object plane 5. The bundle of illumination light 3 may also impinge on the reticle 12 with virtually parallel individual rays.

Fig. 7 shows another illumination of the reticle 12 which is inverse to the illumination according to Fig. 6. A coupling mirror 38 of a coupling optics according to Fig. 7, which otherwise corresponds to the coupling mirror 11 of the embodiment discussed above, has a ring-shaped reflection surface 39 shown in a schematic plan view by an insert in Fig. 7. The ring-shaped reflection surface 39 surrounds an inner through-opening 40 of the coupling mirror 38.

In the illumination example according to Fig. 7, the reticle 12 is exposed to a ring-shaped, in other words annular bundle of illumination light 3. An inner free area 41 of the bundle of illumination light 3 impinging upon the coupling mirror 38 has a slightly greater width than the projection of the through-opening 40 seen by this impinging bundle of illumination light 3, with the result that the bundle of illumination light 3 is completely reflected by the coupling mirror 38 toward the reticle 12.

An imaging optics not shown in Fig. 7, which may be employed in the projection exposure apparatus 1 instead of the imaging optical systems explained above, has a numerical aperture on the object side which is slightly smaller than the numerical aperture on the object side of the edge rays defining the inner boundary of the free area 41 of the bundle of illumination light 3. The numerical aperture of the imaging light 3' on the object side is so small that the imaging light 3' is able to pass the through-opening 40 entirely, in other words there are no losses of imaging light 3' when passing the through-opening 40 of the coupling mirror 38.

On the image side, the imaging optics according to Fig. 7 has a numerical aperture of NA'$_{Abb}$ again.

In the illumination example according to for example Fig. 6, imaging can be performed only with imaging light 3' produced by at least +/- first order of diffraction at the reticle 12, in other words the structures to be imaged. In this case, the zero order of diffraction is thus not used for imaging.

All embodiments of the imaging optics described above have in each case at least one mirror M, with

$$P(M) \le 0,9.$$

A microstructured or nanostructured component is fabricated by means of the projection exposure apparatus 1 as follows: In a first step, the reticle 12 and the wafer 19 are provided. Afterwards, a structure on the reticle 12 is projected onto a light-sensitive layer on the wafer 19 by means of the projection exposure apparatus 1. The light-sensitive layer is then developed to form a microstructure or a nanostructure on the wafer 19, with the result that a microstructured component, for instance a semiconductor component in the form of a highly integrated circuit, is obtained.

**Claims**

1.  Imaging optics (16; 31; 37) for lithographic projection exposure for guiding a bundle of imaging light (3) with a wavelength shorter than 193 nm by means of a plurality of mirrors (M1 to M6) for beam-splitter-free imaging of a reflective object (12) in an object field (4) in an object plane (5) into an image field (17) in an image plane (18), an object field point having a chief ray angle ($\alpha$) which is smaller than 3°,
    with at least one of the mirrors (M1 to M6) being designed as a near-field mirror **characterized in that** the first mirror (M1) being part of a first obscured mirror group (M1, M2) with a through-opening for coupling in illumination light.

2.  Imaging optics (16; 31; 37) for lithographic projection exposure for guiding a bundle of imaging light (3) with a wavelength shorter than 193 nm by means of a plurality of mirrors (M1 to M6) for beam-splitter-free imaging of a reflective object (12) in an object field (4) in an object plane (5) into an image field (17) in an image plane (18),

    - with a first mirror (M1) in the imaging beam path between the object field (4) and the image field (17) having a through-opening (21, 22) for the imaging light (3) to pass through,

    with at least one mirror (M3, M4) being arranged between the first mirror (M1) in the imaging beam path between the object field (4) and the image field (17) and the last mirror (M6) in the imaging beam path between the object field (4) and the image field (17), the reflection surface of the at least one mirror (M3, M4) used for reflecting the imaging light being continuous **characterized in that** the first mirror (M1) being part of a first obscured mirror group (M1, M2) with a through-opening for coupling in illumination light.

3.  Imaging optics according to one of claims 1 to 2, **characterized in that** a first mirror (M1) in the imaging beam path between the object field (4) and the image field (17) is concave while a second mirror (M2) in the imaging beam path between the object field (4) and the image field (17) is convex.

4.  Illumination system comprising

    - an imaging optics (16, 31; 37) according to one of claims 1 to 3;
    - an illumination optics (7; 28) for beam-splitter-free guidance of a bundle of illumination light (3) with a wavelength shorter than 193 nm from a radiation source (2) to an object (12) in an object field (4) in an object plane (5), the object (12) being reflective for the illumination light (3),

    with a design such that for at least one point of the object field (4), the bundle of the illumination light (3) has an energy weighted ray direction of incidence (13) onto the object field (4) which makes an angle with a normal (14) to the object plane (5) which is smaller than 3°.

5.  Illumination system according to claim 4, **characterized by** a coupling mirror (11) of the illumination optics (7; 28) which couples the illumination light (3) into one of the mirrors (M2) of the imaging optics (16; 31; 37) via a through-opening (22).

6.  Illumination system according to claim 4, **characterized by** a coupling mirror (38) of the illumination optics (7; 28) which comprises a through-opening (40) through which the imaging light (3') passes in the imaging beam path of the imaging optics.

7.  Projection exposure apparatus (1) comprising

    - an illumination system according to one of claims 4 to 6;
    - a light source (2) for producing the illumination and imaging light (3).

8.  Method for the fabrication of a structured component, the method comprising the following steps:

- providing a reticle (12) and a wafer (19);
- projecting a structure on the reticle (12) onto a light-sensitive layer of the wafer (19) by means of the projection exposure apparatus (1) according to claim 7;
- producing a microstructure or a nanostructure on the wafer (19).

## Patentansprüche

1. Abbildungsoptik (16; 31; 37) für eine lithografische Projektionsbelichtung zur Führung eines Abbildungslichtbündels (3) mit einer Wellenlänge, die kürzer als 193 nm ist, mithilfe einer Vielzahl von Spiegeln (M1 bis M6) für eine strahlteilerfreie Abbildung eines reflektierenden Objekts (12) in einem Objektfeld (4) in einer Objektebene (5) in ein Bildfeld (17) in einer Bildebene (18), wobei ein Objektfeldpunkt einen Hauptstrahlwinkel ($\alpha$) aufweist, der kleiner als 3° ist,
wobei mindestens einer der Spiegel (M1 bis M6) als ein Nahfeldspiegel ausgelegt ist,
**dadurch gekennzeichnet, dass** der erste Spiegel (M1) Teil einer ersten obskurierten Spiegelgruppe (M1, M2) mit einer Durchgangsöffnung zur Einkopplung von Beleuchtungslicht ist.

2. Abbildungsoptik (16; 31; 37) für eine lithografische Projektionsbelichtung zur Führung eines Abbildungslichtbündels (3) mit einer Wellenlänge, die kürzer als 193 nm ist, mithilfe einer Vielzahl von Spiegeln (M1 bis M6) für eine strahlteilerfreie Abbildung eines reflektierenden Objekts (12) in einem Objektfeld (4) in einer Objektebene (5) in ein Bildfeld (17) in einer Bildebene (18),

- wobei ein erster Spiegel (M1) in dem Abbildungsstrahlengang zwischen dem Objektfeld (4) und dem Bildfeld (17) eine Durchgangsöffnung (21, 22) aufweist, damit das Beleuchtungslicht (3) hindurchgeht,

wobei mindestens ein Spiegel (M3, M4) zwischen dem ersten Spiegel (M1) in dem Abbildungsstrahlengang zwischen dem Objektfeld (4) und dem Bildfeld (17) und dem letzten Spiegel (M6) in dem Abbildungsstrahlengang zwischen dem Objektfeld (4) und dem Bildfeld (17) angeordnet ist, wobei die Reflexionsfläche des mindestens einen Spiegels (M3, M4), der zum Reflektieren des Abbildungslichts verwendet wird, zusammenhängend ist,
**dadurch gekennzeichnet, dass** der erste Spiegel (M1) Teil einer ersten obskurierten Spiegelgruppe (M1, M2) mit einer Durchgangsöffnung zur Einkopplung von Beleuchtungslicht ist.

3. Abbildungsoptik nach einem der Ansprüche 1 bis 2, **dadurch gekennzeichnet, dass** ein erster Spiegel (M1) in dem Abbildungsstrahlengang zwischen dem Objektfeld (4) und dem Bildfeld (17) konkav ist, während ein zweiter Spiegel (M2) in dem Abbildungsstrahlengang zwischen dem Objektfeld (4) und dem Bildfeld (17) konvex ist.

4. Beleuchtungssystem, umfassend:
eine Abbildungsoptik (16, 31; 37) nach einem der Ansprüche 1 bis 3,

- eine Beleuchtungsoptik (7; 28) zur strahlteilerfreien Führung eines Beleuchtungslichtbündels (3) mit einer Wellenlänge, die kürzer als 193 nm ist, von einer Strahlungsquelle (2) zu einem Objekt (12) in einem Objektfeld (4) in einer Objektebene (5), wobei das Objekt (12) für das Beleuchtungslicht (3) reflektierend ist, und mit einer solchen Auslegung, dass für mindestens einen Punkt des Objektfelds (4), das Beleuchtungslichtbündel (3) eine energiegewichtete Einfallsstrahlrichtung (13) auf das Objektfeld (4) aufweist, die einen Winkel zu einer Normalen (14) auf die Objektebene (5) hat, der kleiner als 3° ist.

5. Beleuchtungssystem nach Anspruch 4, **gekennzeichnet durch** einen Kopplungsspiegel (11) der Beleuchtungsoptik (7; 28), der das Beleuchtungslicht (3) durch eine Durchgangsöffnung (22) in einen der Spiegel (M2) der Abbildungsoptik (16; 31; 37) einkoppelt.

6. Beleuchtungssystem nach Anspruch 4, **gekennzeichnet durch** einen Kopplungsspiegel (38) der Beleuchtungsoptik (7; 28), der eine Durchgangsöffnung (40) umfasst, durch die das Abbildungslicht (3') in den Abbildungsstrahlengang der Abbildungsoptik gelangt.

7. Projektionsbelichtungsvorrichtung (1), umfassend:

- ein Beleuchtungssystem nach einem der Ansprüche 4 bis 6;
- eine Lichtquelle (2) zum Erzeugen des Beleuchtungs- und des Abbildungslichts (3).

**8.** Verfahren zum Herstellen einer strukturierten Komponente, wobei das Verfahren die folgenden Schritte umfasst:

- Bereitstellen eines Retikels (12) und eines Wafers (19);
- Projizieren einer Struktur auf dem Retikel (12) auf eine lichtempfindliche Schicht des Wafers (19) mithilfe der Projektionsbelichtungsvorrichtung (1) nach Anspruch 7;
- Erzeugen einer Mikrostruktur oder einer Nanostruktur auf dem Wafer (19).

**Revendications**

**1.** Élément optique de formation d'image (16 ; 31 ; 37) pour exposition par projection lithographique pour le guidage d'un faisceau de lumière de formation d'image (3) ayant une longueur d'onde inférieure à 193 nm au moyen d'une pluralité de miroirs (M1 à M6) pour former une image sans séparateur de faisceau d'un objet réfléchissant (12) dans un champ objet (4) dans un plan objet (5) dans un champ image (17) dans un plan image (18), un point du champ objet ayant un angle de rayon principal ($\alpha$) inférieur à 3°,
avec au moins un des miroirs (M1 à M6) étant conçu comme un miroir de champ proche, **caractérisé en ce que** le premier miroir (M1) fait partie d'un premier groupe de miroirs obscurcis (M1, M2) avec une ouverture de passage pour couplage en lumière d'éclairage.

**2.** Élément optique de formation d'image (16 ; 31 ; 37) pour exposition par projection lithographique pour le guidage d'un faisceau de lumière de formation d'image (3) ayant une longueur d'onde inférieure à 193 nm au moyen d'une pluralité de miroirs (M1 à M6) pour former une image sans séparateur de faisceau d'un objet réfléchissant (12) dans un champ objet (4) dans un plan objet (5) dans un champ image (17) dans un plan image (18),

- avec un premier miroir (M1) sur le trajet du faisceau de formation d'image entre le champ objet (4) et le champ image (17) ayant une ouverture de passage (21, 22) pour que la lumière de formation d'image (3) passe à travers,

avec au moins un miroir (M3, M4) étant disposé entre le premier miroir (M1) sur le trajet du faisceau de formation d'image entre le champ objet (4) et le champ image (17) et le dernier miroir (M6) sur le trajet du faisceau de formation d'image entre le champ objet (4) et le champ image (17), la surface de réflexion de l'au moins un miroir (M3, M4) étant utilisée pour réfléchir la lumière de formation d'image étant continue, **caractérisé en ce que** le premier miroir (M1) fait partie d'un premier groupe de miroirs obscurcis (M1, M2) avec une ouverture de passage pour couplage en lumière d'éclairage.

**3.** Élément optique de formation d'image selon l'une des revendications 1 à 2, **caractérisé en ce qu'**un premier miroir (M1) sur le trajet du faisceau de formation d'image entre le champ objet (4) et le champ image (17) est concave, tandis qu'un second miroir (M2) sur le trajet du faisceau de formation d'image entre le champ objet (4) et le champ image (17) est convexe.

**4.** Système d'éclairage comprenant :

- un élément optique de formation d'image (16, 31 ; 37) selon l'une des revendications 1 à 3 ;
- un élément optique d'éclairage (7 ; 28) pour un guidage sans séparateur de faisceau d'un faisceau de lumière d'éclairage (3) d'une longueur d'onde inférieure à 193 nm provenant d'une source de rayonnement (2) vers un objet (12) dans un champ objet (4) dans un plan objet (5), l'objet (12) étant réfléchissant pour la lumière d'éclairage (3),

avec une conception telle que pour au moins un point du champ objet (4), le faisceau de la lumière d'éclairage (3) a une direction d'incidence de rayon pondérée par l'énergie (13) sur le champ objet (4) qui forme un angle avec une normale (14) au plan objet (5) qui est inférieur à 3°.

**5.** Système d'éclairage selon la revendication 4, **caractérisé par** un miroir de couplage (11) de l'optique d'éclairage (7 ; 28) qui couple la lumière d'éclairage (3) dans un des miroirs (M2) de l'élément optique de formation d'image (16 ; 31 ; 37) par une ouverture de passage (22).

**6.** Système d'éclairage selon la revendication 4, **caractérisé par** un miroir de couplage (38) de l'élément optique d'éclairage (7 ; 28) qui comprend une ouverture de passage (40) à travers laquelle la lumière de formation d'image (3') passe dans le trajet du faisceau de formation d'image de l'élément optique de formation d'image.

**7.** Appareil d'exposition par projection (1) comprenant :

- un système d'éclairage selon l'une des revendications 4 à 6 ;
- une source de lumière (2) pour produire la lumière d'éclairage et la lumière de formation d'image (3).

**8.** Procédé de fabrication d'un composant structuré, le procédé comprenant les étapes suivantes :

- fournir un réticule (12) et une plaquette (19) ;
- projeter une structure sur le réticule (12) sur une couche photosensible de la plaquette (19) au moyen de l'appareil d'exposition par projection (1) selon la revendication 7 ;
- produire une microstructure ou une nanostructure sur la plaquette (19).

Fig. 1

EP 2 513 697 B1

Fig. 2

EP 2 513 697 B1

Fig. 3

15  4  14  12  15

M2

22

3

11

28

3

8

29

30

21

M1

EP 2 513 697 B1

16

Fig. 4

Fig. 5

Fig. 6

Fig. 7

**EP 2 513 697 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20090073392 A1
- US 20080170310 A1
- US 6894834 B2
- US 20030147131 A1
- US 6549270 B1
- DE 102008042917 A1
- US 6353470 B1
- WO 2009024164 A1
- WO 2006069725 A
- US 20070058269 A1